# EUROPÄISCHE PATENTSCHRIFT

(11) **EP 3 646 421 B1**
(45) Veröffentlichungstag und Bekanntmachung des Hinweises auf die Patenterteilung: **06.10.2021**
(21) Anmeldenummer: 18759900.6
(22) Anmeldetag: 20.08.2018
(51) Int. Cl.: H02B 1/54, H02B 13/045

(54) **SCHALTEINRICHTUNG AUFWEISEND ZURRPUNKTE**
SWITCHING DEVICE COMPRISING LASHING POINTS
DISPOSITIF DE COMMUTATION COMPRENANT DES POINTS D'AMARRAGE

(30) Priorität: 28.08.2017 DE 102017214970
(43) Veröffentlichungstag der Anmeldung: 06.05.2020
(73) Patentinhaber: Siemens Energy Global GmbH & Co. KG, 81739 München (DE)
(72) Erfinder: BRADLER, Christian, 14612 Berlin (DE); DAMBIETZ, Hans-Peter, 13589 Berlin (DE); EHRLICH, Ulrike, 16562 Hohen Neuendorf OT Bergfelde (DE); FAHLBUSCH, Peter, 13086 Berlin (DE); GROHALL, Sven, 10961 Berlin (DE); HERTEL, Anne, 13595 Berlin (DE); LUDENIA, Dan, 14621 Schönwalde-Glien OT Schönwalde-Siedlung (DE); ROSE-PÖTZSCH, Alexander, 16341 Panketal (DE); SCHLIEDER, Patrick, 14621 Schönwalde-Glien (DE); SCHMIDT, Anne, 13585 Berlin (DE); SCHOMACHER, Andre, 16548 Glienicke/Nordbahn (DE); ZHAO, Ai Guang, 10589 Berlin (DE)
(86) Internationale Anmeldenummer: PCT/EP2018/072384
(87) Internationale Veröffentlichungsnummer: WO 2019/042798

(56) Entgegenhaltungen:
- EP-A2- 0 690 538
- JP-A- 2017 121 122

## Beschreibung

Die Erfindung betrifft eine Schalteinrichtung aufweisend ein Kapselungsgehäuse sowie Zurrpunkte, wobei das Kapselungsgehäuse einen Flansch aufweist, über dessen Umfang die Zurrpunkte hervorspringen.

Aus dem Prospekt "Gas-insulated switchgear type series 8DN8" geht eine Schalteinrichtung mit einem Kapselungsgehäuse hervor. Die Schalteinrichtung weist ein Traggerüst auf, an welchem Zurrpunkte zum Befestigen der Schalteinrichtung angeordnet sind. Somit ist es möglich, die Schalteinrichtung unmittelbar mit einem Fundament zu verbinden. Nachteilig ist jedoch, dass durch das Traggerüst die Bauhöhe vergrößert wird. Dadurch kann ein Transport erschwert werden. Weiter können erhöhte Umbruchkräfte insbesondere bei Nutzung in erdbebengefährdeten Regionen auf die Schalteinrichtung einwirken. Entsprechend sind mechanische Verstärkungen für diese Anwendungsfälle vorzusehen.

Aus der europäischen Patentanmeldung EP 0 690 538 A2 geht eine metallgekapselte druckgasisolierte Hochspannungsschaltanlage hervor. Dieses Dokument beschreibt einen Zwischenflansch, der an seiner Außenkontur mit angeformten Befestigungsvorsprüngen versehen ist. Schräg verspannte Querstreben verspannen mehrere Zwischenflansche miteinander. Den Figuren der JP 2017-121122A ist ein kastenförmiger Schrank entnehmbar, welcher an Seitenflächen abgestützt ist.

Somit ergibt sich als Aufgabe der Erfindung, eine Schalteinrichtung anzugeben, welche bei reduzierter Bauhöhe eine verbesserte Stabilität aufweist.

Die Aufgabe wird bei einer vorstehend genannten Schalteinrichtung dadurch gelöst, dass die Zurrpunkte derart angeordnet sind, dass der Schwerpunkt der Schalteinrichtung in Verzurrrichtung unterhalb der Zurrpunkte, zwischen den Zurrpunkten und einem Widerlager für die Zurrkräfte liegt, wobei die Verzurrrichtung in einer vertikalen Richtung liegt und durch die Summe der Kräfte, welche auf die Schalteinrichtung einwirken, bestimmt wird und der Flansch von einem Getriebedeckel verschlossen ist.

Eine Schalteinrichtung ist eine Einrichtung zum Schalten eines Strompfades. Der zu schaltende Strompfad ist bevorzugt zumindest teilweise im Innern eines Kapselungsgehäuses angeordnet. Als solches bildet das Kapselungsgehäuse eine mechanische Barriere für die in seinem Innern angeordneten Abschnitte des zu schaltenden Strompfades. Als Schalteinrichtung können beispielsweise Leistungsschalter, Trennschalter, Lastschalter, Erdungsschalter usw. Verwendung finden. Zum Schalten des Strompfades können relativ zueinander bewegbare Schaltkontaktstücke genutzt werden.

Zurrpunkte sind Punkte an der Schalteinrichtung, an welchen Kräfte zum Fixieren derselben eingeleitet werden können. Ein Fixieren kann sowohl temporär als auch dauerhaft über die Zurrpunkte erfolgen. Als Zurrpunkte können beispielsweise Ösen, Gewindebohrungen, Ausnehmungen, Vorsprünge, Haken usw. dienen.

Über die Zurrpunkte besteht die Möglichkeit, die Schalteinrichtung in eine Verzurrrichtung zu belasten. Die Verzurrrichtung wird durch die Summe der Kräfte, welche auf die Schalteinrichtung einwirken, bestimmt. Die Verzurrrichtung liegt in einer vertikalen Richtung. Der Schwerpunkt der Schalteinrichtung liegt dabei in Verzurrrichtung bevorzugt unterhalb einer Fläche, die von den Zurrpunkten umschlossen ist. Der Schwerpunkt liegt zwischen den Zurrpunkten und einem Widerlager (z. B. Aufstellfläche) für die Zurrkräfte. Entsprechend kann bei einem Verzurren, also einem Verspannen der Schalteinrichtung gegen eine Aufstellfläche, die Lage der Schalteinrichtung durch den Schwerpunkt zusätzlich stabilisiert werden. Die Aufstellfläche liegt dabei quer zur Verzurrrichtung, so dass die Aufstellfläche als Widerlager für in Verzurrrichtung wirkende Kräfte wirken kann. Bevorzugt kann die Aufstellfläche im Wesentlichen lotrecht zur Verzurrrichtung ausgerichtet sein. Die Zurrpunkte können etwa in einer Ebene liegen, welche im Wesentlichen parallel zu einer Aufstellfläche verläuft. Weiter weist die Anordnung der Zurrpunkte oberhalb des Schwerpunktes den Vorteil auf, dass die Zurrpunkte auch als Kranpunkte genutzt werden können. Bei einem Aufhängen der Schalteinrichtung an den Zurrpunkten wird so eine stabile Lage eingenommen. So ist ein einfacher Wechsel der Belastung der Zurrpunkte möglich ohne die Stabilität der Schalteinrichtung zu gefährden.

Weiter ist vorgesehen, dass das Kapselungsgehäuse einen Flansch aufweist, über dessen Umfang die Zurrpunkte hervorspringen.

Mittels eines Flansches ist ein Zugang zum Innern des Kapselungsgehäuses möglich. Entsprechend kann der Flansch auch über einen Flanschdeckel verschlossen werden. Der Flansch kann beispielsweise als Ringflansch ausgeführt sein. Der Flansch begrenzt eine Flanschöffnung. Die Zurrpunkte können den Flansch am Umfang des Flansches überragen. So sind exponierte Punkte gebildet, an welchen Zurrkräfte angreifen können. Die Zurrpunkte können beispielsweise im Wesentlichen einander diametral gegenüberliegend angeordnet sein. Die Zurrpunkte sind bevorzugt frei von einer Überdeckung durch einen den Flansch verschließenden Flanschdeckel gehalten. Der Flansch kann beispielsweise ein Blattflansch sein, dessen Blatt von Zurrpunkten im Wesentlichen in radialer Richtung überragt wird. Die Zurrpunkte können zumindest teilweise in den Flansch übergehen. Somit ist in einfacher Weise eine Kraftverteilung in den Flansch hinein möglich. Der Schwerpunkt der Schaltanlage kann von dem Flansch überspannt sein.

Vorteilhaft kann weiter vorgesehen sein, dass die Zurrpunkte zum Flansch axial versetzt angeordnet sind.

Durch einen axialen Versatz besteht die Möglichkeit, Kräfte zum Verzurren unterhalb des Flansches in das Kapselungsgehäuse einzuleiten. Somit ist eine Trennung von Flansch und Zurrpunkt möglich, wobei weiterhin Kräfte im gleichen Bereich des Kapselungsgehäuses angreifen können.

Weiter kann vorgesehen sein, dass zwischen zwei Zurrpunkten mantelseitig am Kapselungsgehäuse Anbauteile abgestützt sind.

Am Kapselungsgehäuse können Anbauteile abgestützt sein. So können beispielsweise Steuerschränke, Antriebsgehäuse usw. am Kapselungsgehäuse befestigt sein. Zwischen zwei Zurrpunkten verläuft eine lineare Verbindungsachse, zu welcher sich Ebenen erstrecken, die im Wesentlichen parallel zueinander und rechtwinklig zu der linearen Verbindungsachse ausgerichtet sind. Jeweils eine der Ebenen verläuft durch einen Zurrpunkt. Die beiden Ebenen begrenzen den Raum, in welchem Anbauteile mantelseitig am Kapselungsgehäuse angeordnet werden können. Somit besteht die Möglichkeit, am Kapselungsgehäuse Ausleger aus Anbauteilen zu befestigen, welche zwischen den Ebenen begrenzt sich mantelseitig an das Kapselungsgehäuse anschließen. Insbesondere können die Zurrpunkte weiterhin den Flansch überragen. Insbesondere kann vorgesehen sein, dass der Flansch dabei quer zur mantelseitigen Ausladung der Anbauteile (in Richtung der Verbindungsachse) eine größere Erstreckung, zumindest aber die gleiche Erstreckung wie die Anbauteile aufweisen. Entsprechend können die Zurrpunkte genutzt werden, um sowohl parallel zu den Ebenen, zwischen welchen sich die Anbauteile erstrecken, als auch lotrecht zu diesen Ebenen (in Richtung der Verbindungsachse) ein Abspannen bzw. Anschlagen von Befestigungsmitteln vorzunehmen.

Vorteilhafterweise kann weiter vorgesehen sein, dass jeweils zwischen zwei Zurrpunkten mantelseitig am Kapselungsgehäuse Anbauteile auf entgegengesetzten Seiten des Kapselungsgehäuses angeordnet sind.

Jeweils zwischen zwei Zurrpunkten kann sich jeweils eine lineare Verbindungsachse erstrecken. Bevorzugt sollten die Verbindungsachsen zwischen jeweils zwei Zurrpunkten, zwischen denen sich jeweils die Anbauteile an entgegengesetzten Seiten des Kapselungsgehäuses befinden, im Wesentlichen parallel zueinander angeordnet sein. Entsprechend können die Anbauteile im Wesentlichen lotrecht zu diesen Achsen jeweils mantelseitig vom Kapselungsgehäuse fortragen. Beiderseits des Kapselungsgehäuses befindliche Anbauteile können so zueinander fluchtend angeordnet sein. Vorteilhafterweise sollte in Fluchtrichtung der Anbauteile ein Ausladen der Zurrpunkte jeweils derart erfolgen, dass zu den Ebenen (lotrecht zur Verbindungsachse, durch die Zurrpunkte verlaufend), welche die Anbauteile in Fluchtrichtung parallel begrenzen, ein lotrechtes bzw. paralleles Verspannen über die jeweiligen Zurrpunkte möglich ist.

Dabei kann vorteilhafterweise vorgesehen sein, dass die Anbauteile die Zurrpunkte in Verzurrrichtung überragen.

In Verzurrrichtung liegt der Schwerpunkt der Schalteinrichtung unterhalb der Zurrpunkte. Mit einem Überragen der Zurrpunkte durch die Anbauteile kann zusätzlicher Bauraum für die Anbauteile genutzt werden, wobei weiterhin ein Verzurren bzw. Stabilisieren der Schalteinrichtung an den Zurrpunkten möglich ist. Ein Überragen kann in Verzurrrichtung sowohl in beiden Richtungen als auch nur in einer Richtung erfolgen. Die Anbauteile sind dabei derart angeordnet, dass weiterhin der Schwerpunkt der Schalteinrichtung unterhalb der Zurrpunkte liegt. Dabei ist in Richtung der Schwerkraftachse eine Überdeckung der Zurrpunkte durch Anbauteile nicht vorgesehen. Somit sind die Zurrpunkte insbesondere oberhalb des Schwerpunktes frei zugänglich, wodurch eine Nutzung der Verzurrpunkte auch zum Kranen der Schalteinrichtung erfolgen kann.

Eine weitere vorteilhafte Ausgestaltung kann vorsehen, dass der Flansch einen stirnseitigen Abschluss des Kapselungsgehäuses über einer Aufstellfläche bildet.

Über einer Aufstellfläche, gegen welche ein Verzurren der Schalteinrichtung unter Nutzung der Verzurrpunkte erfolgen kann, kann ein stirnseitiger Abschluss des Kapselungsgehäuses über einen Flansch erfolgen. Der Flansch kann dabei mittels eines geeigneten Flanschdeckels (gegebenenfalls fluiddicht) verschlossen werden. Über den stirnseitigen Abschluss des Kapselungsgehäuses ist gewährleistet, dass keine weiteren Kapselungsgehäuseteile oberhalb des stirnseitigen Abschlusses befindlich sind. Dadurch ist ein geeigneter Zugang zu den Zurrpunkten auch aus Richtung des Flansches sowie aus radialen Richtungen auf den Flansch zu ermöglichen.

Weiter ist vorgesehen, dass der Flansch von einem Getriebedeckel verschlossen ist.

Zum Verschießen eines Flansches kann ein Getriebedeckel dienen. Mittels des Getriebedeckels ist ein Einleiten einer Bewegung in das Innere des Kapselungsgehäuses ermöglicht. Die Bewegung kann so beispielsweise außerhalb des Kapselungsgehäuses erzeugt werden und in das Innere des Kapselungsgehäuses unter Passage des Getriebedeckels übertragen werden. Dadurch besteht weiterhin die Möglichkeit, eine Bewegung gedichtet in das Innere des Kapselungsgehäuses hineinzuleiten. Der Getriebedeckel kann beispielsweise von einer drehbaren Welle oder einer axial bewegbaren Stange durchsetzt sein. Ein Durchsetzen des Getriebedeckels kann dabei fluiddicht erfolgen, so dass der Getriebedeckel auch Teil einer fluiddichten Barriere sein kann.

Weiterhin kann dabei vorteilhaft vorgesehen sein, dass am Flansch eine Antriebseinrichtung für relativ zueinander bewegbare Schaltkontaktstücke der Schalteinrichtung abgestützt ist.

Eine Antriebseinrichtung kann dazu dienen, relativ zueinander bewegbare Schaltkontaktstücke der Schalteinrichtung, welche sich bevorzugt im Innern des Kapselungsgehäuses befinden, zu einer Relativbewegung zu veranlassen. Die Antriebseinrichtung kann dabei zumindest teilweise am Flansch gehalten sein. Beispielsweise kann die Antriebseinrichtung unter Zwischenschaltung des Getriebedeckels am Flansch gestützt sein.

Vorteilhafterweise kann weiter vorgesehen sein, dass das Kapselungsgehäuse ein Druckbehälter ist.

Das Kapselungsgehäuse kann als Druckbehälter ausgebildet sein. Als solches kann das Innere des Kapselungsgehäuses mit einem Über- oder Unterdruck beaufschlagt werden. Das Kapselungsgehäuse ist dazu als solches fluiddicht ausgebildet. Beispielsweise kann das Innere des Kapselungsgehäuses mit einem elektrisch isolierenden Fluid befüllt sein, mit welchem eine Isolation von zueinander bewegbaren Schaltkontaktstücken der Schalteinrichtung vorgenommen wird. Darüber hinaus kann das elektrisch isolierende Fluid auch passive Bauteile wie Phasenleiter, Spannungswandler und dergleichen elektrisch isolieren. Als elektrisch isolierende Fluide sind beispielsweise fluorhaltige Medien wie Schwefelhexafluorid, Fluornitril, Fluorketon sowie stickstoffhaltige Medien wie Stickstoff, gereinigte atmosphärische Luft usw. verwendbar. Neben der Verwendung von gasförmigen Fluiden ist auch ein Einsatz von flüssigen Isoliermedien zulässig. Um einer Druckdifferenz widerstehen zu können, weist das Kapselungsgehäuse eine entsprechende mechanische Stabilität auf. Diese mechanische Stabilität kann genutzt werden, um Anbauteile am Kapselungsgehäuse abzustützen. Zurrpunkte können in der Oberfläche des Kapselungsgehäuses angeordnet sein und aus dem Kapselungsgehäuse bzw. dessen Oberfläche hervorspringen. Anbauteile selbst sind von Zurrpunkten freigehalten. Die Anbauteile selbst sind nicht notwendigerweise als Druckbehälter auszuführen.

Im Folgenden wird ein Ausführungsbeispiel der Erfindung schematisch in einer Zeichnung gezeigt und nachfolgend näher beschrieben. Dabei zeigt die
- Figur 1: eine perspektivische Ansicht einer Schalteinrichtung, die
- Figur 2: eine Draufsicht auf die Schalteinrichtung wie aus der Figur 1 bekannt und die
- Figur 3: eine perspektivische Ansicht eines Zurrpunktes.

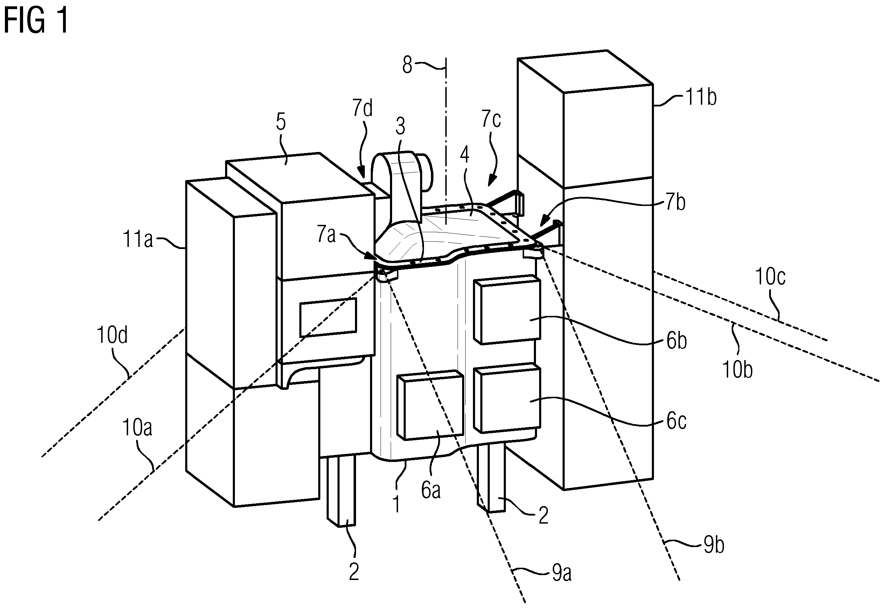

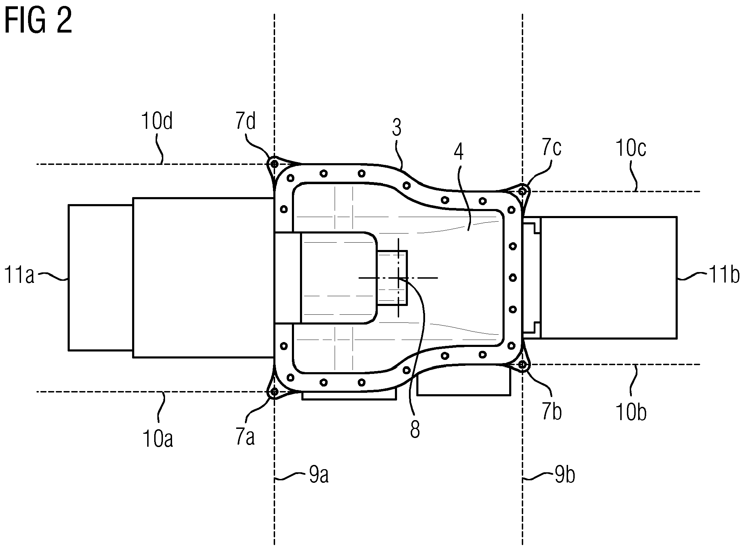

Die Schalteinrichtung in der Figur 1 weist ein Kapselungsgehäuse 1 auf. Das Kapselungsgehäuse 1 ist vorliegend als Druckbehälter ausgebildet und nimmt in seinem Inneren relativ zueinander bewegbare Schaltkontaktstücke der Schalteinrichtung auf. Eine elektrische Einbindung der Schalteinrichtung in ein Elektronetz kann beispielsweise über Durchführungen erfolgen, welche in eine Wandung des Kapselungsgehäuses 1 eingelassen sind. Dort können beispielsweise Kabel mittels Steckverbindern angeschlossen werden. Durchführungen können beispielsweise von Anbauteilen 11a, 11b umgeben sein, so dass durch die Anbauteile 11a, 11b ein mechanischer Schutz gegeben ist. Das Kapselungsgehäuse 1 ist in seinem Inneren mit einem elektrisch isolierenden Fluid unter Überdruck befüllt. Bevorzugt handelt sich um ein fluorhaltiges Fluid wie Schwefelhexafluorid, Fluornitril, Fluorketon oder ein stickstoffhaltiges Fluid wie Stickstoff sowie Stickstoffgemische wie gereinigte atmosphärische Luft. Das Kapselungsgehäuse 1 ist aufrecht stehend angeordnet und gegenüber einer Aufstellfläche 2 abgestützt. Abgewandt von der Aufstellfläche 2 weist das Kapselungsgehäuse 1 stirnseitig einen Flansch 3 auf. Der Flansch 3 weist eine unregelmäßige mehreckige Struktur auf (vergleiche auch die Draufsicht in der Figur 2). Der Flansch 3 ist mit einem Flanschdeckel 4 verschlossen. Der Flanschdeckel 4 ist dabei fluiddicht mit dem Flansch 3 verbunden, so dass ein Entweichen von dem im Inneren des Kapselungsgehäuses angeordneten elektrisch isolierenden Fluid entgegengewirkt ist. Der Flanschdeckel 4 ist vorliegend als Getriebedeckel ausgebildet, das heißt, in einer Anformung ist ein Einleiten einer Bewegung über Getriebeelemente wie beispielsweise Wellen oder Stangen in das Innere des Kapselungsgehäuses 1 ermöglicht. Eine Transmission in das Innere des Kapselungsgehäuses 2 erfolgt dabei bevorzugt fluiddicht. Zur Erzeugung einer Bewegung ist am Getriebedeckel eine Antriebseinrichtung 5 befestigt. Die Antriebseinrichtung 5 ist versetzt zum Flansch 3 angeordnet. Es kann jedoch auch vorgesehen sein, dass die Antriebseinrichtung 5 sich zumindest teilweise bis über den Flansch 3 ausdehnt.

Mantelseitig sind am Kapselungsgehäuse 1 drei weitere Antriebseinrichtungen 6a, 6b, 6c angeordnet. Über die weiteren Antriebseinrichtungen 6a, 6b, 6c sind weitere Bewegungen fluiddicht in das Innere des Kapselungsgehäuses 1 einkoppelbar (z. B. für Erdungsschalter, Trennschalter usw.). Am Umfang des Flansches 3 sind ein erster Zurrpunkt 7a, ein zweiter Zurrpunkt 7b, ein dritter Zurrpunkt 7c sowie ein vierter Zurrpunkt 7d angeordnet. In der perspektivischen Ansicht nach Figur 1 sind lediglich der erste Zurrpunkt 7a sowie der zweite Zurrpunkt 7b unmittelbar erkennbar. Der dritte Zurrpunkt 7c sowie der vierte Zurrpunkt 7d sind in der Figur 1 durch Körperkanten verdeckt.

In der Draufsicht der Figur 2 sind alle vier Zurrpunkte 7a, 7b, 7c, 7d sichtbar. Die Zurrpunkte 7a, 7b, 7c, 7d springen über den Umfang des Flansches 3 hervor, so dass die Zurrpunkte 7a, 7b, 7c, 7d in Richtung einer Schwerkraftachse 8 frei von einer Überdeckung durch den Flansch 3 beziehungsweise den Flanschdeckel 4 sind. Die Schwerkraftachse 8 entspricht im Wesentlichen einer Verzurrrichtung. Im Umlauf der Zurrpunkte 7a, 7b, 7c ist eine Fläche begrenzt, unterhalb welcher in Richtung der Schwerpunktachse 8 der Schwerpunkt der Schalteinrichtung befindlich ist. Entsprechend sind Zurrpunkte 7a, 7b, 7c, 7d bezogen auf die Aufstellfläche 2 oberhalb des Schwerpunktes der Schalteinrichtung angeordnet.

Jeweils zwei der Zurrpunkte 7a, 7d sowie 7b, 7c sind über eine Verbindungsachse 9a, 9b miteinander verbunden. Die Verbindungsachsen 9a, 9b sind im Wesentlichen parallel zueinander ausgerichtet. Dabei weist der Abstand des ersten Zurrpunktes 7a zum vierten Zurrpunkt 7d einen größeren Betrag in Richtung der Verbindungsachse 9a auf als der Abstand des zweiten Zurrpunktes 7b zum dritten Zurrpunkt 7c in Richtung der zugeordneten Verbindungsachse 9b. Entsprechend ergeben sich im Wesentlichen lotrecht zu den Verbindungsachsen 9a, 9b ausgehend von den jeweiligen Zurrpunkten 7a, 7b, 7c, 7d Achsen, welche jeweils in einer Ebene 10a, 10b, 10c, 10d liegen. Die Ebenen 10a, 10b, 10c, 10d begrenzen mantelseitig an gegenüberliegenden Seiten des Kapselungsgehäuses 1 Bereiche, innerhalb welchen Anbauteile 11a, 11b mantelseitig mit dem Kapselungsgehäuse 1 verbunden sind. Die Anbauteile 11a, 11b sind am Kapselungsgehäuse 1 zumindest teilweise abgestützt. Als Anbauteil 11a, 11b kann beispielsweise auch die Antriebseinrichtung 5 ausgeformt sein. Die Anbauteile 11a, 11b sind dabei derart ausgebildet, dass diese den Flansch 3 in Richtung der Schwerpunktachse 8 überragen (vgl. Figur 1). Weiterhin überragen die Anbauteile 11a, 11b das Kapselungsgehäuse 1. Dabei ist vorliegend ein Überragen des Kapselungsgehäuses 1 durch die Anbauteile 11a, 11b sowohl oberhalb als auch unterhalb der Stirnseiten des Kapselungsgehäuse 1 in Richtung der Schwerpunktachse 8 vorgesehen.

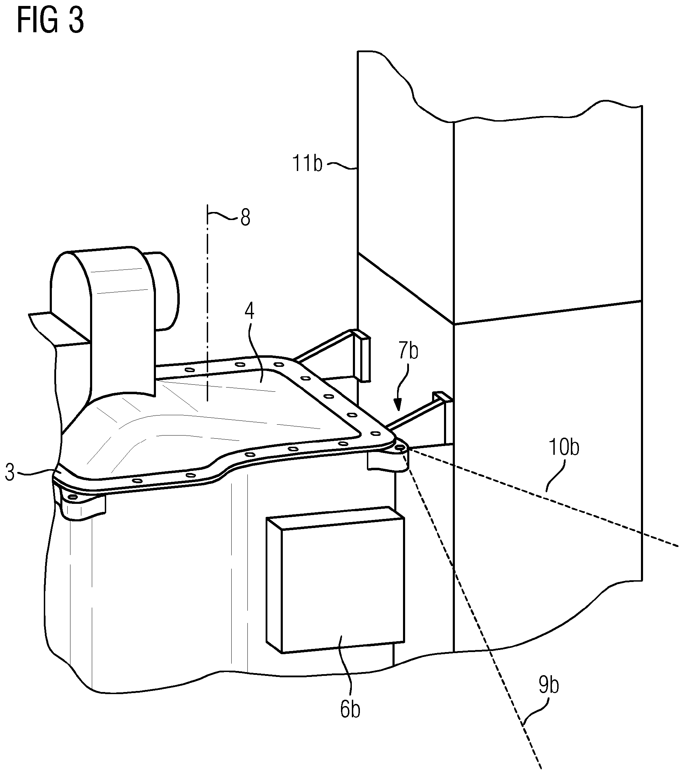

Die Figur 3 zeigt stellvertretend für alle Zurrpunkte 7a, 7b, 7c, 7d ein Detail des zweiten Zurrpunktes 7b. Der zweite Zurrpunkt 7b ist bezüglich der Schwerkraftachse 8 axial beabstandet zum Flansch 3, mantelseitig am Kapselungsgehäuse 1 angeordnet. Vorliegend ist der Zurrpunkt 7b stoffschlüssig mit dem Kapselungsgehäuse 1 verbunden. Beispielsweise kann im Rahmen eines Gussverfahrens für das Kapselungsgehäuse 1 ein Zurrpunkt 7a, 7b, 7c, 7d im Rahmen des Gusses mit ausgeformt werden. Vorliegend ist der zweite Zurrpunkt 7b in Richtung der Schwerpunktache 8 axial beabstandet zu dem Flansch 3 angeordnet. Die Zurrpunkte 7a, 7b, 7c, 7d sind bevorzugt in einer Ebene liegend angeordnet, welche im Wesentlichen lotrecht zur Schwerpunktachse 8 ausgerichtet ist. Alternativ kann jedoch auch vorgesehen sein, dass die Zurrpunkte 7a, 7b, 7c, 7d als Teil des Flansches 3 in dem Flansch 3 liegen beziehungsweise zumindest teilweise durch den Flansch 3 ausgeformt sind. Die Zurrpunkte 7a, 7b, 7c, 7d sind dabei bevorzugt symmetrisch, am Umlauf des Flansches 3 verteilt, angeordnet. Bevorzugt können Zurrpunkte 7a, 7b, 7c, 7d jeweils diametral gegenüberliegend angeordnet sein, so dass ein gleichmäßiges Verzurren der Schalteinrichtung möglich ist. Ein Verzurren ausgehend von den Zurrpunkten 7a, 7b, 7c, 7d erfolgt vorzugsweise in Richtung der jeweiligen Aufstellfläche 2, wobei die einzelnen Kräfte bevorzugt verschieden von einer Parallelen zu der Schwerpunktachse 8 in die Zurrpunkte 7a, 7b, 7c, 7d angeleitet werden. In Summe ergibt sich bevorzugt eine Verzurrrichtung in Richtung der Schwerpunktachse 8. Ein Verlauf beispielsweise von Spannlaschen ist dabei bevorzugt jeweils in einem Sektor vorgesehen, welcher in Richtung der Schwerpunkteachse 8 gesehen, zwischen den jeweiligen Verbindungsachsen 9a, 9b sowie den jeweiligen Ebenen 10a, 10b, 10c, 10d eingeschlossen ist. In Summe der an den Zurrpunkten 7a, 7b, 7c 7d angreifenden Zurrkräfte wird das Kapselungsgehäuse 1 mit der Stirnseite, an welcher der Flansch 3 angeordnet ist, in Richtung der Schwerpunktachse 8 gegen die Aufstellfläche 2 gepresst. Der Schwerpunkt der Schalteinrichtung liegt dabei unterhalb der Ebene, in welcher die Zurrpunkte 7a, 7b, 7c, 7d liegen. Weiterhin ist der Schwerpunkt, in Richtung der Schwerpunktachse 8 gesehen, innerhalb eines von den Zurrpunkten 7a, 7b, 7c, 7d eingeschlossenen Fläche angeordnet. Entsprechend kann aufgrund der Zugänglichkeit der Zurrpunkte 7a, 7b, 7c, 7d aus entgegengesetzter Richtung zur Aufstellfläche 2 auch ein Zugang mit Kranmittel vorgesehen sein, so dass auch ein Heben der Schaltanlage über die Zurrpunkte 7a, 7b, 7c, 7d möglich ist. Vorliegend sind die Zurrpunkte 7a, 7b, 7c, 7d mit einer Durchgangsbohrung versehen, in welchen beispielsweise Ösen, Haken, Bolzen usw. festlegbar sind, um Kräfte über Anschlagmittel sicher an den Zurrpunkten 7a, 7b, 7c, 7d angreifen zu lassen.

### Bezugszeichenliste

- 1: Kapselungsgehäuse
- 2: Aufstellfläche
- 3: Flansch
- 4: Flanschdeckel
- 5: Antriebseinrichtung
- 6a, 6b, 6c, 6d: weitere Antriebseinrichtungen
- 7a: erster Zurrpunkt
- 7b: zweiter Zurrpunkt
- 7c: dritter Zurrpunkt
- 7d: vierter Zurrpunkt
- 8: Schwerpunktachse
- 9a, 9b: Verbindungsachse
- 10a, 10b, 10c, 10d: Ebene
- 11a, 11b: Anbauteil

## Patentansprüche

1. Schalteinrichtung aufweisend ein Kapselungsgehäuse (1) sowie Zurrpunkte (7a, 7b, 7c, 7d), wobei das Kapselungsgehäuse (1) einen Flansch (3) aufweist, über dessen Umfang die Zurrpunkte (7a, 7b, 7c, 7d) hervorspringen,
**dadurch gekennzeichnet, dass**
die Zurrpunkte (7a, 7b, 7c, 7d) derart angeordnet sind, dass der Schwerpunkt der Schalteinrichtung in Verzurrrichtung (8) unterhalb der Zurrpunkte (7a, 7b, 7c, 7d), zwischen den Zurrpunkten(7a, 7b, 7c, 7d) und einem Widerlager für die Zurrkräfte liegt, wobei die Verzurrrichtung (8) in einer vertikalen Richtung liegt und durch die Summe der Kräfte, welche auf die Schalteinrichtung einwirken, bestimmt wird und der Flansch (4) von einem Getriebedeckel (4) verschlossen ist.

2. Schalteinrichtung nach Anspruch 1,
**dadurch gekennzeichnet, dass**
die Zurrpunkte (7a, 7b, 7c, 7d) zum Flansch (3) axial versetzt angeordnet sind.

3. Schalteinrichtung nach Anspruch 1 oder 2,
**dadurch gekennzeichnet, dass**
zwischen zwei Zurrpunkten (7a, 7b, 7c, 7d) mantelseitig am Kapselungsgehäuse (1) Anbauteile (11a, 11b) abgestützt sind.

4. Schalteinrichtung nach einem der Ansprüche 1 bis 3,
**dadurch gekennzeichnet, dass**
jeweils zwischen zwei Zurrpunkten (7a, 7b, 7c, 7d) mantelseitig am Kapselungsgehäuse (1) Anbauteile (11a, 11b) auf entgegengesetzten Seiten des Kapselungsgehäuses (1) angeordnet sind.

5. Schalteinrichtung nach Anspruch 3 oder 4,
**dadurch gekennzeichnet, dass**
die Anbauteile (11a, 11b) Zurrpunkte (7a, 7b, 7c, 7d) in Verzurrrichtung (8) überragen.

6. Schalteinrichtung nach einem der Ansprüche 1 bis 5,
**dadurch gekennzeichnet, dass**
der Flansch (3) einen stirnseitigen Abschluss des Kapselungsgehäuses (1) über einer Aufstellfläche (2) bildet.

7. Schalteinrichtung nach einem der Ansprüche 1 bis 6,
**dadurch gekennzeichnet, dass**
am Flansch (3) eine Antriebseinrichtung (5) für relativ zueinander bewegbare Schaltkontaktstücke der Schalteinrichtung abgestützt ist.

8. Schalteinrichtung nach einem der Ansprüche 1 bis 7,
**dadurch gekennzeichnet, dass**
das Kapselungsgehäuse (5) ein Druckbehälter ist.

## Claims

1. Switchgear having an enclosure housing (1) and anchoring points (7a, 7b, 7c, 7d), wherein the enclosure housing (1) has a flange (3), beyond the circumference of which the anchoring points (7a, 7b, 7c, 7d) project,
**characterized in that**
the anchoring points (7a, 7b, 7c, 7d) are arranged such that the centre of gravity of the switchgear is located below the anchoring points (7a, 7b, 7c, 7d), between the anchoring points (7a, 7b, 7c, 7d) and a counter-bearing for the anchoring forces, in the anchoring direction (8), wherein the anchoring direction (8) is located in a vertical direction and is determined by the sum of the forces which act on the switchgear, and the flange (4) is closed by a gear cover (4).

2. Switchgear according to Claim 1,
**characterized in that**
the anchoring points (7a, 7b, 7c, 7d) are arranged axially offset with respect to the flange (3).

3. Switchgear according to Claim 1 or 2,
**characterized in that**
add-on parts (11a, 11b) are supported laterally on the enclosure housing (1), between two anchoring points (7a, 7b, 7c, 7d).

4. Switchgear according to one of Claims 1 to 3,
**characterized in that**
add-on parts (11a, 11b) are arranged laterally on the enclosure housing (1) on opposite sides of the enclosure housing (1), in each case between two anchoring points (7a, 7b, 7c, 7d).

5. Switchgear according to Claim 3 or 4,
**characterized in that**
the add-on parts (11a, 11b) extend beyond anchoring points (7a, 7b, 7c, 7d) in the anchoring direction (8).

6. Switchgear according to one of Claims 1 to 5,
**characterized in that**
the flange (3) forms an end-face termination of the enclosure housing (1) above a mounting surface (2).

7. Switchgear according to one of Claims 1 to 6,
**characterized in that**
a drive device (5) for mutually relatively movable switching contacts of the switchgear is supported on the flange (3).

8. Switchgear according to one of Claims 1 to 7,
**characterized in that**
the enclosure housing (5) is a pressurized vessel.

## Revendications

1. Dispositif de coupure comportant un boîtier (1) de blindage ainsi que des points (7a, 7b, 7c, 7d) d'amarrage, le boîtier (1) de blindage ayant une bride (3) sur le pourtour de laquelle font saillies les points (7a, 7b, 7c, 7d) d'amarrage,
**caractérisé en ce que** les points (7a, 7b, 7c, 7d) d'amarrage sont disposés de manière à ce que le centre de gravité du dispositif de coupure se trouve dans la direction (8) d'amarrage en dessous des points (7a, 7b, 7c, 7d) d'amarrage entre les points (7a, 7b, 7c, 7d) d'amarrage et une butée pour les forces d'amarrage, la direction (8) d'amarrage étant une direction verticale et étant déterminée par la somme des forces, qui s'appliquent au dispositif de coupure, et la bride (4) est fermée par un couvercle (4) de mécanisme.

2. Dispositif de coupure suivant la revendication 1,
**caractérisé en ce que** les points (7a, 7b, 7c, 7d) d'amarrage sont disposés de manière décalée axialement par rapport à la bride (3).

3. Dispositif de coupure suivant la revendication 1 ou 2,
**caractérisé en ce que** des parties (11a, 11b) annexes sont appuyées du côté latéral sur le boîtier (1) de blindage entre deux points (7a, 7b, 7c, 7d) d'amarrage.

4. Dispositif de coupure suivant l'une des revendications 1 à 3,
**caractérisé en ce que** des parties (11a, 11b) annexes sont disposées sur des côtés opposés du boîtier (1) de blindage du côté latéral respectivement entre deux points (7a, 7b, 7c, 7d) d'amarrage.

5. Dispositif de coupure suivant la revendication 3 ou 4,
**caractérisé en ce que** les parties (11a, 11b) annexes dépassent les points (7a, 7b, 7c, 7d) d'amarrage dans la direction (8) d'amarrage.

6. Dispositif de coupure suivant l'une des revendications 1 à 5,
**caractérisé en ce que** la bride (3) forme une fermeture du côté frontal du boîtier (1) de blindage par l'intermédiaire d'une surface (2) de montage.

7. Dispositif de coupure suivant l'une des revendications 1 à 6,
**caractérisé en ce que** sur la bride (3) s'appuie un dispositif (5) d'entraînement de pièces de contact mobiles l'une par rapport à l'autre du dispositif de coupure.

8. Dispositif de coupure suivant l'une des revendications 1 à 7,
**Caractérisé en ce que** le boîtier (5) de blindage est un récipient résistant à la pression.
